# EUROPÄISCHE PATENTSCHRIFT

(11) **EP 2 193 544 B1**
(45) Veröffentlichungstag und Bekanntmachung des Hinweises auf die Patenterteilung: **12.10.2011**
(21) Anmeldenummer: 08775325.7
(22) Anmeldetag: 24.07.2008
(51) Int. Cl.: H01L 23/538, H01L 23/367, H01L 23/36

(54) **VORRICHTUNG ZUM KÜHLEN VON ELEKTRONISCHEN BAUTEILEN**
DEVICE FOR COOLING ELECTRONIC COMPONENTS
DISPOSITIF POUR REFROIDIR DES COMPOSANTS ÉLECTRONIQUES

(30) Priorität: 17.09.2007 DE 102007044358
(43) Veröffentlichungstag der Anmeldung: 09.06.2010
(73) Patentinhaber: Robert Bosch GmbH, 70442 Stuttgart (DE)
(72) Erfinder: REIBER, Harald, 73061 Ebersbach-Rosswaelden (DE)
(86) Internationale Anmeldenummer: PCT/EP2008/059708
(87) Internationale Veröffentlichungsnummer: WO 2009/037037

(56) Entgegenhaltungen:
- WO-A-2004/034428
- DE-A1- 4 110 373
- DE-A1-102006 009 021
- US-A- 4 954 878
- US-A1- 2007 057 284

## Beschreibung

### Stand der Technik

Aufgrund der fortschreitenden Miniaturisierung können in heutigen mikroelektronischen Schaltkreisen (ICs) auf kleiner Fläche immer mehr Transistoren untergebracht werden. Damit einher geht eine ständig steigende Verlustwärme, die zu zahlreichen Problemen führen kann. So besteht die Gefahr von Schäden an den Bauteilen selbst, die zu einem Funktionsausfall führen können, sowie die Gefahr von Materialermüdungseffekten durch wärmebedingte Ausdchnungs- und Biegungsvorgänge des Halbleiter-Substrats und je nach Montageart des IC auf der Leiterplatte.

Aufgrund dieser Problematik wurden in der Vergangenheit zahlreiche Lösungsvorschläge veröffentlicht, wovon die meisten eine effizientere Wärmeableitung hin zu einem Kühlkörper auf der dem Chip gegenüberliegenden Seite der Leiterplatte zum Ziel haben. So schlägt die DE 41 10 373 vor, ICs an der Oberseite über ein wärmeleitendes Medium an einen Kühlkörper und an der Unterseite unter Verwendung von Zwischensubstraten an eine Leiterplatte zu koppeln. Weiter schlägt die DE 41 07 312 A1 die Nutzung von Durchkontaktierungen in der Leiterplatte vor, über die der Abtransport der Wärmeenergie erfolgen kann. Durch eine Isolationsschicht zwischen der Leiterplatte und dem Kühlkörper wird sichergestellt, dass keine elektrische Verbindung zwischen dem IC und dem Kühlkörper existiert. Der Signalaustausch und die Stromzufuhr zum Chip geschehen in dieser Variante über Pins am Rand des Chipgehäuses, bei anderen Varianten ohne Gehäuse über Bonddrähte, die ebenfalls von der Substratkante aus wegführen.

Eine Verbesserung dieses Konzepts wird in der DE 197 52 797 A1 offenbart. Da der Einsatz der Isolationsschicht zur elektrischen Trennung von Chip-Substrat und Kühlkörper mit einem schlechteren Wirkungsgrad beim Wärmetransport einhergeht, der zu einem Wärmestau und in Folge dessen zu einer Überhitzung und Beschädigung der Schaltung führt, wird vorgeschlagen, eine dicke Zwischenschicht als Wärmeleitplatte zwischen dem Kühlkörper und dem Schaltungsträger zu verwenden, die für eine bessere seitliche Wärmeverteilung sorgen soll. Auf diese Weise verteilt sich die Wärme besser und auf eine größere Fläche, was insbesondere bei kurzfristigen, starken Hitzeschüben zu einer Verbesserung führt. Die kupferkaschierten Flächen der Leiterplatte können im Gegensatz dazu aufgrund einer fertigungstechnisch bedingten Beschränkung auf eine maximale Materialdicke von 80 µm dieses nur sehr viel schlechter leisten. Die elektrische Isolation vom Kühlkörper geschieht in der DE 197 52 797 A1 weiterhin durch eine wärmeleitende, elektrisch isolierende Schicht.

Bei heutigen Steuergerätegehäusen findet der Wärmetransport in ähnlicher Weise statt. Der auf einer Leiterplatte befestigte IC gibt seine Wärme über Wärmebumps an einen Kühlkörper ab, auf der das Trägermedium mit einem wärmeleitenden, elektrisch isolierenden Kleber befestigt ist. Wärmebumps erhöhen jedoch die Kosten für die Produktion der Leiterplatte und schränken die flächenmäßige Nutzbarkeit ein. Weitere Nachteile ergeben sich durch den Wärmetransport durch die Leiterplatte, da die wärmebedingte Materialausdehnung zu Verspannungen und in der Folge zu Ermüdungserscheinungen führen kann. Auch kann der Wärmetransport durch die Leiterplatte hindurch nur mit eingeschränkter Geschwindigkeit und Effektivität erfolgen. Durch Verwendung von Wärmebumps wird auβerdem die Leitungsführung unter dem IC erschwert. Durch die vorliegende Erfindung werden die Nachteile des Stands der Technik gelöst.

### Offenbarung der Erfindung

Die vorliegende Erfindung löst diese Nachteile durch Realisation einer neuartigen Vorrichtung zum Kühlen von elektronischen Bauteilen, im Folgenden Slug-Up-Kühlung genannt, die durch den Einsatz eines Abstandshalters zwischen einem elektronischen Bauteil, insbesondere einem Halbleiterprodukt, beispielsweise einem Integrierten Schaltkreises (IC), und einer Leiterplatte ermöglicht wird. Eine elektrische Verbindung des elektronischen Bauteils mit der Leiterplatte erfolgt durch den Abstandshalter, der in einer bevorzugten Ausführung der Erfindung wiederum durch eine Leiterplatte realisiert wird, d.h. durch den Abstandshalter hindurch oder um diesen herum führen elektrische Leitungen vom elektronischen Bauteil zur Leiterplatte. Auf der gegenüberliegenden Seite des elektronischen Bauteils wird ein Wärmeleitmedium, z.B. eine Paste oder eine wärmeleitende Kontaktfläche, im Folgenden Wärmepad genannt, aufgebracht, an das sich ein Kühlkörper, insbesondere ein Gehäuse oder eine Bodenplatte eines Steuergerätes, anschließt, die den Abtransport der Wärmeenergie übernimmt.

Insgesamt ergibt sich ein mehrschichtiger Aufbau, der sich dadurch auszeichnet, dass die Richtung des Wärmetransports entgegengesetzt der Richtung der elektrischen Signalübertragung verläuft. Der Einsatz des Abstandshalters ermöglicht es, dass sowohl elektronische Bauteile mit Gehäuse, als auch elektronische Bauteile ohne Gehäuse zwischen die Leiterplatte und den Kühlkörper eingepasst werden können, indem unterschiedliche je nach Einsatzzweck ergebende Höhen durch Abstandshalter variabler Dicke ausgeglichen werden.

Die erfindungsgemäße Vorrichtung löst die im Stand der Technik vorhandenen Nachteile. Durch Wegfall der Wärmebumps sind einfachere und günstigere Leiterplatten möglich, sowie eine freie Platzierbarkeit der Bauelemente auf der Leiterplatte. Insgesamt wird dadurch eine bessere Flächenausnutzung der Leiterplatte möglich.

Weiterhin ergibt sich eine erhöhte Vibrationsfestigkeit durch eine räumliche Verteilung der mechanischen Fixierung des elektronischen Bauteils im Gehäuse: Zum einen erfolgt eine Fixierung auf dem Kühlkörper durch das Wärmeleitmedium oder das Wärmeleitpad auf einer Seite des elektronischen Bauteils, zum anderen ergibt sich auf der anderen Seite des elektronischen Bauteils eine Fixierung an der Leiterplatte durch den Abstandshalter.

Da die Einheit aus Leiterplatte und wenigstens einem elektronischen Bauteil nicht mit dem Kühlkörper verklebt werden muss, sondern in einer Variante der Erfindung über ein Verbindungselement fixiert wird, beispielsweise über eine seitliche angebrachte Halterung, kann die Einheit zu Reparatur- oder Ersatzzwecken leichter ausgetauscht werden. In einer bevorzugten Ausgestaltung der Erfindung erfolgt die Verbindung der Einheit aus Leiterplatte und wenigstens einem elektronischen Bauteil mit dem Kühlkörper nur durch den Einsatz wenigstens eines Abstandshalters, der mit Hilfe einer der üblichen, etablierten Verbindungstechniken, z.B. Verpressen, Verkleben oder Verlöten, auf einer Seite an der Leiterplatte fixiert ist und auf der anderen Seite mit einem elektronischen Bauteil verklebt oder verlötet ist, das mit dem Kühlkörper durch das Wärmeleitmedium verbunden ist.

Durch Wegfall der Wärmebumps ergeben sich zusätzliche Leitungsfiihrungsressourcen unter den zu kühlenden elektronischen Bauteilen. Desweiteren ist nur ein Wärmeübergang vorhanden, da der Wärmetransport durch die Leiterplatte entfallen kann, so dass sich eine geringere Erwärmung der Leiterplatte und weniger Verspannungen aufgrund von thermisch bedingten Dehnungen und Kontraktionen ergeben.

Ferner kann das Gehäuse, insbesondere ein Steuergerät-Gehäuse, durch Einsatz der erfindungsgemäßen Vorrichtung einfacher und kompakter ausfallen als im Stand der Technik, da die Ausnutzung der Leiterplatte durch eine dichtere Platzierung der elektronischen Bauteile verbessert wird.

### Kurze Beschreibung der Zeichnungen

Ausführungsbeispiele der Erfindung sind in den Zeichnungen dargestellt und in der nachfolgenden Beschreibung näher erläutert.

Es zeigen
- Figur 1: eine im Stand der Technik verwendete Anordnung zur Kühlung von elektroni- schen Bauteilen innerhalb eines Gehäuses,
- Figur 2a: die erfindungsgemäße Vorrichtung zur Slug-Up-Kühlung von elektronischen Bauteilen,
- Figur 2b: eine Ausschnittsvergrößerung der Figur 2a,
- Figur 3: eine Ausführungsvariante der erfindungsgemäßen Vorrichtung mit Durchkon- taktierungen in einer Leiterplatte und
- Figur 4: eine Variante der erfindungsgemäßen Vorrichtung mit einem seitlich verlöte- ten Abstandshalter.

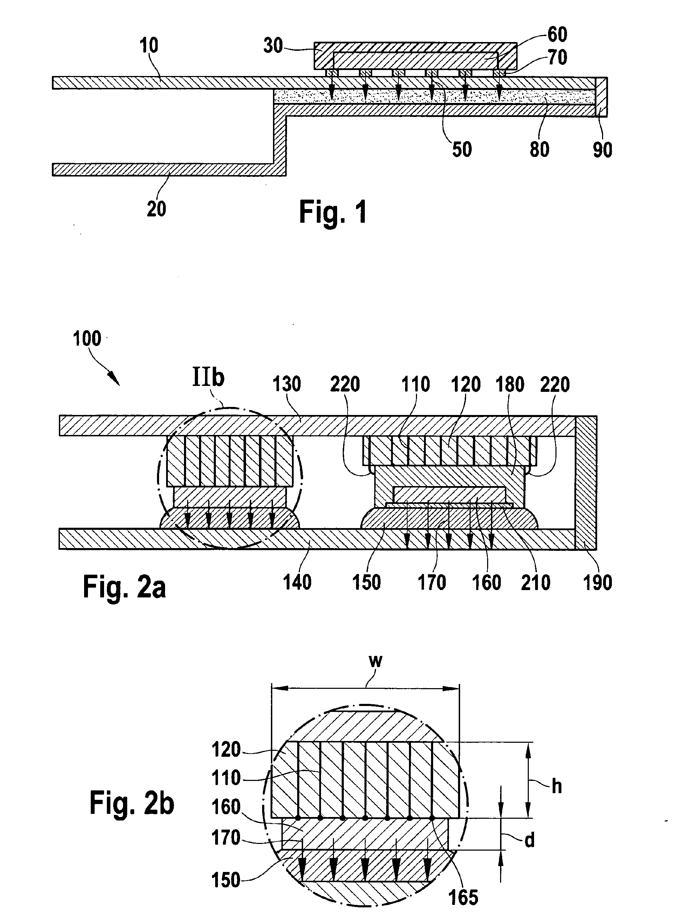

In Figur 1 ist ein elektronisches Bauteil 60, insbesondere ein Integrierter Schaltkreis (IC), in einem Gehäuse 30 abgebildet, das auf einer Seite, typischerweise der Unterseite, mit einer Leiterplatte 10 über Wärmepads 70 thermisch leitend verbunden ist. Auf derselben Seite erfolgt ein Wärmefluss 50 durch die Leiterplatte 10 und durch eine Schicht hindurch, die einen wärmeleitenden Kleber 80 umfasst und die Leiterplatte 10 auf einem Kühlkörper 20 fixiert. In weiteren Varianten wird die Leiterplatte 10 mit dem Kühlkörper 20 zusätzlich über ein beispielsweise seitlich angebrachtes Verbindungselement 90 verankert, verschraubt oder dergleichen. Aus der Schicht mit dem wärmeleitenden Kleber 80 verläuft der Wärmefluss 50 weiter in den Kühlkörper 20 hinein.

### Ausführungsformen der Erfindung

In Figur 2a ist eine Vorrichtung 100 zum Kühlen von wenigstens einem elektronischen Bauteil 160 dargestellt, wobei ein Wärmeleitmedium 150, beispielsweise eine Paste oder eine wärmeleitende Kontaktfläche (Wärmepad), auf einer Seite des elektronischen Bauteils 160, typischerweise der Unterseite, für einen Wärmefluss 170 in einen Kühlkörper 140 sorgt, der in einer bevorzugten Variante als Bodenplatte, aber in weiteren Varianten auch als Deckel oder Gehäuseteil eines Gerätes, insbesondere eines Motor-Steuergerätes, ausgeführt sein kann.

Eine elektrische Verbindung 110 wird mit einer Leiterplatte 130 auf der anderen Seite des elektronischen Bauteils 160 hergestellt, wobei die elektrische Verbindung 110 durch oder um einen Abstandshalter 120 herum erfolgt, der in einer bevorzugten Ausgestaltung der Erfindung durch eine Leiterplatte realisiert ist. Weitere marktübliche Materialien, die sich als Träger elektrischer Bauteile eignen, beispielsweise Träger aus Keramik, Kunststoff oder Gummi, können in weiteren Ausführungsformen der Erfindung für den Abstandshalter 120 eingesetzt werden.

Wie der Darstellung gemäß Figur 2a entnommen werden kann, wird der Hohlraum zwischen der Leiterplatte 130 und dem Kühlkörper 140 durch eine Schichtanordnung ausgefüllt, die zum einen den Abstandhalter 120, das darunter liegende Bauteilgehäuse 180 des elektronischen Bauteils umfasst sowie das Wärmeleitmedium 150. Wie aus dem in Figur 2a dargestellten Schichtaufbau hervorgeht, erfolgt ein Signalfluss über die elektrische Verbindung 110 vom elektronischen Bauteil 160 durch dessen Gehäuse 180 an die Leiterplatte 130. Dem Signalfluss entgegengesetzt ist der Wärmefluss 170 gerichtet, der sich vom durch das Gehäuse 180 umschlossenen elektronischen Bauteil 160 über das Wärmeleitmedium 150 zum Kühlkörper 140 hin richtet. Durch die erfindungsgemäß vorgeschlagene Vorrichtung 100 zum Kühlen von elektronischen Bauteilen 160 sind der elektrische Signalfluss durch die elektrische Verbindung 110 und der Wärmefluss 170 voneinander entkoppelt. Durch die erfindungsgemäß vorgeschlagene Lösung wird ein konstanter Abstand der zu kühlenden elektronischen Bauteile 160 in Bezug auf die Leiterplatte 130 sowie in Bezug auf den Kühlkörper 140 durch Einsatz entsprechend konfigurierter Abstandhalter 120 erreichbar. Die in Figur 2a im Schnitt dargestellte Anordnung kann sowohl mit integrierten Schaltkreisen als elektronische Bauteile 160 als auch mit ICs, die ohne Gehäuse beschaffen sind, in Flip-Chip-Technik bestückt werden. Des Weiteren ist durch den Einsatz der erfindungsgemäß vorgeschlagenen Abstandhalter 120 einerseits die Entkopplung des elektrischen Signalflusses an die Leiterplatte 130 vom Wärmefluss 170 und andererseits bei entsprechender Dimensionierung der Abstandhalter 120 eine gemischte Bestückung eine Steuergerätes mit integrierten Schaltkreisen bzw. elektronischen Bauteilen 160 mit und ohne Gehäuse sowie in unterschiedlichen Gehäusehöhen gemischt zu erzielten.

Gemäß der Darstellung in Figur 2a ist nur ein Wärmeübergang in Gestalt des Wärmeflusses 170 vom elektronischen Bauteil 160 an den Kühlkörper 140 verwirklicht. Die elektrische Verbindung 110 vom elektronischen Bauteil 160 durch dessen Gehäuse 180 und die elektrische Verbindung 110 zur Leiterplatte 130 ist vom Wärmefluss 170 völlig unabhängig und wird auch durch diesen - so zum Beispiel durch eine Änderung des elektrischen Widerstandes - nicht beeinträchtigt.

Wie in der Darstellung gemäß Figur 2a dargestellt ist, sind bei der dort im Schnitt wiedergegebenen erfindungsgemäß vorgeschlagenen Vorrichtung 100 zum Kühlen von elektronischen Bauteilen 160 die Leiterplatte 130 und der Kühlkörper 140 durch ein Verbindungselement 190, welches hier als vertikal verlaufender Steg ausgebildet ist, miteinander verbunden. Ein gleichmäßiger Wärmefluss 170 in den schenkelförmig ausgebildeten Kühlkörper 140 der Vorrichtung 100 wird durch eine dünne auf dem Wärmeleitmedium 150 aufgenommenen Hitze-Verteiler 210 erreicht. Dieser vergleichmäßigt die vom elektronischen Bauteil 160 abgegebene Wärme hinsichtlich einer gleichmäßigen Flächenbeaufschlagung, so dass der in Figur 2a dargestellte gleichmäßig verlaufende, auf den Kühlkörper 140 gerichtete Wärmefluss 170 erreicht wird, der dahingehend vergleichmäßigt ist, dass keine Bereiche auftreten, in denen eine zu hohe lokale Wärmeabfuhr entsteht.

Wie der Darstellung gemäß Figur 2b in vergrößertem Maßstab entnehmbar ist, dann ermöglicht es der Abstandshalter 120, das mindestens eine elektronische Bauteil 160 auf eine definierte Höhe über dem Kühlkörper 140 zu bringen, indem eine Dicke h des Abstandshalters 120 beispielsweise durch Abschleifen oder Wahl einer geeigneten Materialstärke so angepasst ist, dass der Abstand zwischen dem elektronischen Bauteil 160 und der Leiterplatte 130 lückenlos überbrückt wird. Kommen mehr als ein elektronisches Bauteil 160 zum Einsatz, so werden entsprechend viele Abstandshalter 120 eingesetzt, die jeweils eine für die Überbrückung der Distanz zwischen dem jeweiligen elektronischen Bauteil 160 und der Leiterplatte 130 spezifische Dicke h aufweisen und so an die jeweilige, im Allgemeinen nicht identische Dicke d des jeweiligen elektronischen Bauteils 160 angepasst sind. Auf diese Weise wird sichergestellt, dass alle elektronischen Bauteile 160 den gleichen Abstand zum Kühlkörper 140 aufweisen und damit die erfindungsgemäße Kühlvorrichtung erst möglich wird.

Aus der in vergrößertem Maßstab wiedergegebenen Darstellung gemäß Figur 2b lässt sich entnehmen, dass in diesem Falle eine Oberseite des elektronischen Bauteiles 160 durch Lotperlen 165 mit einer elektrischen Verbindung 110 verbunden ist. Die elektrische Verbindung 110 erstreckt sich ausgehend von der Lotperle 165 an der Oberseite des elektronischen Bauteiles 160 in vertikale Richtung an die in Figur 2a dargestellte Leiterplatte 130. Während aus der Darstellung gemäß Figur 2b hervorgeht, dass die Oberseite des elektronischen Bauteiles 160 über die elektrischen Verbindungen 110 kontaktiert ist, zeigt Figur 2b auch, dass sich der Wärmefluss 170 von der Unterseite des elektronischen Bauteiles 116 gleichmäßig über dessen plane Unterseite verteilt durch das Wärmeleitmedium 150 in Richtung auf den in Figur 2a dargestellten Kühlkörper 140 erstreckt. Eine Breite w des Abstandhalters ist in der Figur 2b so gewählt, dass diese die Breite des elektronischen Bauteiles 160 geringfügig übersteigt. Der Abstand zwischen der Unterseite der Leiterplatte 130 und der Oberseite des Kühlkörpers 140 wird der Darstellung gemäß Figur 2b folgend, durch die Dicke h des Abstandhalters 120, die Dicke d des elektronischen Bauteiles 160 sowie die Dicke des Wärmeleitmediums 150 spaltfrei überbrückt.

In der Darstellung gemäß Figur 2b ist die Verbindung an der unteren Planseite des elektronischen Bauteiles 160 mit dem Wärmeleitmedium 150 ohne Zwischenschaltung des in Figur 2a dargestellten Hitze-Verteilers 210 ausgebildet.

Weiterhin wird es durch den Einsatz des mindestens einen Abstandshalters 120 möglich, wenigstens ein elektronisches Bauteil 160 ohne ein Bauteil-Gehäuse 180 und wenigstens ein elektronisches Bauteil 160 mit einem Bauteil-Gehäuse 180 einzusetzen. Ein Hitzeverteiler (Heat-Slug) 210, der typischerweise Metall beinhaltet und unter dem wenigstens einen in einem Bauteil-Gehäuse 180 befindlichen elektronischen Bauteil 160 angeordnet ist, sorgt in einer bevorzugten Variante für eine gleichmäßige Verteilung des Wärmeflusses 170 über die Fläche des elektronischen Bauteils 160. In anderen Anwendungen wird auf den Hitze-verteiler 210 verzichtet, ohne dass dadurch vom Kern der vorliegenden Erfindung abgewichen wird.

Die Breite w des Abstandshalters 120 richtet sich nach der Breite des wenigstens einen elektronischen Bauteils 160 und ist im typischen Anwendungsfall um wenige Millimeter größer, als das wenigstens eine elektronischen Bauteils 160. Somit ist Platz für eine Kontaktfläche zur elektrischen Verbindung des wenigstens einen elektronischen Bauteils 160 über mindestens ein Anschlussbein 220 mit dem wenigstens einen Abstandshalter 120 geschaffen. In weiteren Anwendungsfällen wird die elektrische Verbindung 110 des wenigstens einen elektronischen Bauteils 160 mit dem wenigstens einen Abstandshalter 120 über mindestens eine Lotperle 165 (Lotbumps) zwischen dem wenigstens einen elektronischen Bauteil 160 und dem wenigstens einen Abstandshalter 120 bewerkstelligt. Solche elektrische Verbindungen 110 kommen beispielsweise in der Flip-Chip-Technik und bei BGA-Gehäusen häufig vor.

Die Leiterplatte 130 ist in einer Variante der Erfindung (vgl. Figur 2a) über ein seitliches Verbindungselement 190 an dem Kühlkörper 140 fixiert, kann jedoch auch ohne eine solches Verbindungselement 190 an dem Kühlkörper 140 befestigt werden, beispielsweise durch Einsatz der Kombination aus Abstandshalter 120, elektronischem Bauteil 160 und Wärmeleitmedium 150 als schichtweise zusammengesetztes Verbindungselement.

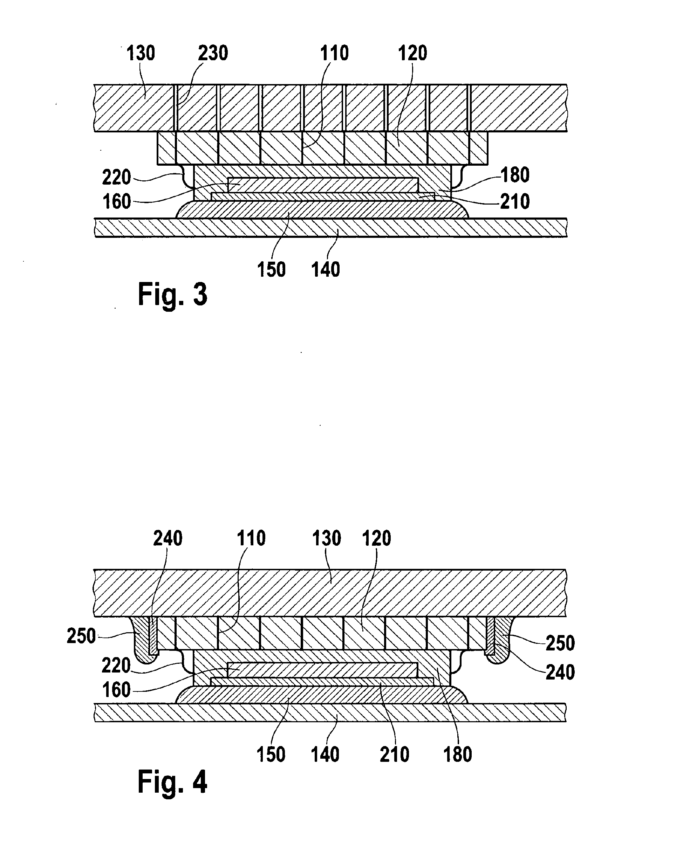

In Figur 3 ist die erfindungsgemäße Vorrichtung zum Kühlen des wenigstens einen elektronischcn Bauteils 160 in einer weiteren Ausführungsvariante dargestellt.

Die wenigstens eine elektrische Verbindung 110 erfolgt dabei durch den Abstandshalter 120 hindurch, beispielsweise durch einlagige oder gestapelte Durchkontaktierungen 230, und kontaktiert auf der dem elektronischen Bauteil 160 gegenüberliegenden Seite des Abstandshalters 120 wenigstens eine Durchkontaktierung 230 in der Leiterplatte 130. Die wenigstens eine Durchkontaktierung 230 wird in einer bevorzugten Ausgestaltung so platziert, dass sie die wenigstens eine elektrische Verbindung 110 des Abstandshalters 120 unmittelbar berührt, indem ihre seitliche Position identisch gewählt wird. In einer anderen Variante der Erfindung kann die seitliche Position der wenigstens einen elektrischen Verbindung 110 des Abstandshalters 120 jedoch auch verschieden von der seitlichen Position der wenigstens einen Durchkontaktierung 230 in der Leiterplatte 130 ausfallen. In solchen Anwendungsfällen wird der elektrische Kontakt dann typischerweise durch Leiterbahnstrukturen in der Leiterplatte 130 oder dem Abstandshalter 120 hergestellt.

Die erfindungsgemäße Vorrichtung 100 zum Kühlen des wenigstens einen elektronischen Bauteils 160 wird typischerweise dadurch realisiert, dass bei der Produktion der Leiterplatte 130 wenigstens eine zusätzliche Leiterplattenlage aufgebracht wird, die als Abstandshalter 120 dient. Alternativ kann in einer weiteren Variante der Erfindung der wenigstens eine Abstandshalter 120 auf der Leiterplatte 130 aufgeklebt werden oder wie ein herkömmlicher IC gelötet werden. In Figur 4 ist der Abstandshalter 120 durch Einsatz eines Lots 250 an der Leiterplatte 130 befestigt. Die elektrische Verbindung zwischen dem Abstandshalter 120 ist in dieser Variante durch eine Anschlusskappe 240 realisiert, die jeweils am seitlichen Ende des Abstandshalters 120 angebracht ist und über die Verbindung aus Lot 250 fixiert ist.

Beiden Ausführungsvarianten gemäß der Figuren 3 und 4 ist gemeinsam, dass sich unterhalb des elektronischen Bauteiles 160 ein plattenförmig ausgebildeter Hitze-Verteiler 210 befindet. Der Hitze-Verteiler 210 kontaktiert die untere Planseite des elektronischen Bauteiles 160 und sorgt für eine Vergleichmäßigung des Wärmeflusses 170 in Richtung auf den Kühlkörper 140. Mittels des Hitze-Verteilers 210, der unter thermisch besonders hoch belasteten elektronischen Bauteilen 160 angeordnet ist und die obere Planseite des Wärmeleitmediums 150 spaltfrei kontaktiert, können lokale Wärmespitzen bzw. Temperaturspitzen vermieden werden und eine gleichmäßige Beaufschlagung sowohl des Wärmeleitmediums 150 als auch des diesen kontaktierenden Kühlkörpers 140 realisiert werden. In der Darstellung gemäß der Figuren 3 und 4 erfolgt der Wärmetransport vom elektronischen Bauteil 160 in Richtung auf den Kühlkörper 140, während der elektrische Signalfluss vom elektronischen Bauelement 140 über das diesen umschließende Bauteilgehäuse 180, über die elektrischen Verbindungen 110 durch den Abstandshalter an die Leiterplatte 130 erfolgt. In der in Figur 3 dargestellten Ausführungsvariante fallen die einzelnen sich im Wesentlichen in vertikale Richtung erstreckenden elektrischen Verbindungen 110 mit den in der Leiterplatte 130 vorgesehenen Durchkontaktierungen 230 zusammen.

In der in Figur 4 dargestellten Ausführungsform der der erfindungsgemäß vorgeschlagenen Vorrichtung 100 zum Kühlen ist der Abstandshalter 120 unter Zwischenschaltung von Anschlusskappen 240 die von Lot 250 umschlossen sind, mit der Unterseite der Leiterplatte 130 kontaktiert. Mit Bezugszeichen 220 sind Anschlussbeine analog zu den in Figur 2a dargestellten Anschlussbeinen gezeigt, über welche das Gehäuse 180 des elektronischen Bauelementes 160 mit den elektrischen Verbindungen 110, die den Abstandshalter 120 im Wesentlichen in vertikale Richtung durchziehen, elektrisch verbunden sind.

## Patentansprüche

1. Vorrichtung (100) zum Kühlen wenigstens zweier sich zwischen einer Leiterplatte (130) und einem Kühlkörper (140), insbesondere in einem Steuergerät befindlichen elektronische Bauteile (160),
- wobei wenigstens zwei der elektronischen Bauteile (160) eine unterschiedliche Bauhöhe (d) aufweisen und
- jedes der elektronischen Bauteile (160) auf einer Seite mit dem Kühlkörper (140) durch ein Wärmeleitmedium (150) verbunden ist und
- auf der anderen Seite zwischen der Leiterplatte (130) und jedem der wenigstens zwei elektronischen Bauteile (160) jeweils ein Abstandshalter (120) angeordnet ist und
- jeder der Abstandshalter (120) wenigstens eine elektrische Verbindung (110) des jeweiligen elektronischen Bauteils (160) mit der Leiterplatte (130) bildet, wobei
- ein Wärmefluss (170) von dem jeweiligen elektronischen Bauteil (160) durch das Wärmeleitmedium (150) zu dem Kühlkörper (140) erfolgt und der Signalfluss von oder zu dem jeweiligen elektronischen Bauteil (160) durch die wenigstens eine elektrische Verbindung (110) des Abstandshalters (120) erfolgt, wodurch der Wärmefluss (170) von dem Signalfluss entkoppelt ist,
**dadurch gekennzeichnet, dass**
- mindestens zwei der Abstandshalter (120) durch jeweils eine weitere Leiterplatte (120) mit wenigstens einer leitungsführenden Schicht gegeben sind, und
- als elektrische Verbindung (110) bei mindestens einem Abstandshalter (120) mindestens eine Durchkontaktierung vorgesehen ist, und
- dass mindestens zwei der Abstandshalter (120) eine unterschiedliche Dicke (h) aufweisen.

2. Vorrichtung (100) nach einem der vorhergehenden Ansprüche, **dadurch gekennzeichnet, dass** das zu kühlende Bauteil (160) ein Halbleiterbauteil ist.

3. Vorrichtung (100) nach einem der vorhergehenden Ansprüche, **dadurch gekennzeichnet, dass** es sich bei dem zu kühlenden Bauteil (160) um einen Integrierten Schaltkreis (IC) handelt.

4. Vorrichtung (100) nach einem der vorhergehenden Ansprüche, **dadurch gekennzeichnet, dass** die Vorrichtung (100) wenigstens ein elektronischen Bauteil (160) umfasst, das von einem Gehäuse (180) umschlossen ist.

5. Vorrichtung (100) nach einem der vorhergehenden Ansprüche, **dadurch gekennzeichnet, dass** die Vorrichtung (100) sowohl wenigstens ein elektronisches Bauteil (160) in einem Gehäuse (180), als auch wenigstens ein elektronisches Bauteil (160) ohne Gehäuse umfasst.

6. Vorrichtung (100) nach einem der vorhergehenden Ansprüche, **dadurch gekennzeichnet, dass** die Leiterplatte (130) wenigstens eine Durchkontaktierung (230) umfasst, welche die wenigstens eine elektrische Verbindung (110) zum Abstandshalter (120) herstellt, und die wenigstens eine Durchkontaktierung (230) seitlich so ausgerichtet ist, dass ein direkter elektrischer Kontakt zwischen der wenigstens einen Durchkontaktierung (230) und der wenigstens einen elektrischen Verbindung (110) hergestellt ist.

7. Steuergerät-Gehäuse, **dadurch gekennzeichnet, dass** das Steuergerät-Gehäuse eine Vorrichtung (100) nach einem der vorangehenden Ansprüche zum Kühlen wenigstens eines elektronischen Bauteils (160) umfasst.

## Claims

1. Device (100) for cooling at least two electronic components (160) situated between a printed circuit board (130) and a heat sink (140), in particular in a control unit
- wherein at least two of the electronic components (160) have a different structural height (d), and
- each of the electronic components (160) is connected on one side to the heat sink (140) by a heat-conducting medium (150) and
- a respective spacer (120) is arranged on the other side between the printed circuit board (130) and each of the at least two electronic components (160),
- each of the spacers (120) forms at least one electrical connection (110) of the respective electronic component (160) to the printed circuit board (130), wherein
- a heat flow (170) from the respective electronic component (160) through the heat-conducting medium (150) to the heat sink (140) and the signal flow takes places from or to the respective electronic component (160) through the at least one electrical connection (110) of the spacer (120), as a result of which the heat flow (170) is decoupled from the signal flow,
**characterized in that**
- at least two of the spacers (120) are provided by in each case a further printed circuit board (120) with at least one line-carrying layer, and
- at least one plated-through hole is provided as electrical connection (110) in the case of at least one spacer (120) and
- **in that** at least two of the spacers (120) have a different thickness (h).

2. Device (100) according to Claim 1, **characterized in that** the component (160) to be cooled is a semiconductor component.

3. Device (100) according to either of the preceding claims, **characterized in that** the component (160) to be cooled is an integrated circuit (IC).

4. Device (100) according to any of the preceding claims, **characterized in that** the device (100) comprises at least one electronic component (160) which is enclosed by a housing (180).

5. Device (100) according to any of the preceding claims, **characterized in that** the device (100) comprises both at least one electronic component (160) in a housing (180) and at least one electronic component (160) without a housing.

6. Device (100) according to any of the preceding claims, **characterized in that** the printed circuit board (130) comprises at least one plated-through hole (230) which produces the at least one electrical connection (110) with respect to the spacer (120), and the at least one plated-through hole (230) is oriented laterally in such a way that a direct electrical contact is produced between the at least one plated-through hole (230) and the at least one electrical connection (110).

7. Control unit housing, **characterized in that** the control unit housing comprises a device (100) according to any of the preceding claims for cooling at least one electronic component (160).

## Revendications

1. Dispositif (100) de refroidissement d'au moins deux composants électroniques (160) se trouvant entre une plaquette de circuit imprimé (130) et un corps refroidissant (140), notamment dans un appareil de commande,
- dans lequel au moins deux des composants électroniques (160) présentent une hauteur d'installation (d) différente et
- chacun des composants électroniques (160) est relié sur un côté au corps refroidissant (140) par l'intermédiaire d'un milieu de conduction thermique (150) et
- sur l'autre côté entre la plaquette de circuit imprimé (130) et chacun des au moins deux composants électroniques (160) est respectivement disposée une entretoise (120) et
- chacune des entretoises (120) forme au moins une liaison électrique (110) du composant électronique (160) respectif avec la plaque de circuit imprimé (130), dans lequel
- un flux thermique (170) a lieu depuis le composant électronique respectif (160) au corps refroidissant (140) en passant par le milieu de conduction thermique (150) et le flux de signalisation depuis ou vers le composant électronique respectif (160) a lieu par l'intermédiaire d'au moins une liaison électrique (110) de l'entretoise (120), moyennant quoi le flux thermique (170) est découplé du flux de signalisation,
**caractérisé en ce que**
- au moins deux des entretoises (120) sont données par respectivement une autre plaquette de circuit imprimé (120) avec au moins une couche guidant la conduction, et
- comme liaison électrique (110) sur au moins une entretoise (120), au moins un contact traversant est prévu, et
- au moins deux des entretoises (120) présentent une épaisseur (h) différente.

2. Dispositif (100) selon la revendication 1, **caractérisé en ce que** le composant à refroidir (160) est un composant à semi-conducteurs.

3. Dispositif (100) selon une des revendications précédentes, **caractérisé en ce que** le composant à refroidir (160) consiste en un circuit intégré (IC).

4. Dispositif (100) selon une des revendications précédentes, **caractérisé en ce que** le dispositif (100) comprend au moins un composant électronique (160), qui est enveloppé par un logement (180).

5. Dispositif (100) selon une des revendications précédentes, **caractérisé en ce que** le dispositif (100) comprend non seulement au moins un composant électronique (160) dans un logement (180) mais aussi au moins un composant électronique (160) sans logement.

6. Dispositif (100) selon une des revendications précédentes, **caractérisé en ce que** la plaquette de circuit imprimé (130) comprend au moins un contact traversant (230), qui produit au moins une liaison électrique (110) vers l'entretoise (120), et le au moins un contact traversant (230) est aligné latéralement de telle sorte qu'un contact électrique direct entre le au moins un contact traversant (230) et la au moins une liaison électrique (110) soit produit.

7. Logement d'appareil de commande, **caractérisé en ce que** le logement d'appareil de commande comprend un dispositif (100) selon une des revendications précédentes pour refroidir au moins un composant électronique (160).
